Europäisches Patentamt

European Patent Office

Office européen des brevets

(19)

(11) Numéro de publication : **0 317 014 B1**

(12) **FASCICULE DE BREVET EUROPEEN**

(45) Date de publication du fascicule du brevet :
**19.02.92 Bulletin 92/08**

(51) Int. Cl.$^5$ : **G11C 29/00, G06F 11/26**

(21) Numéro de dépôt : **88202543.0**

(22) Date de dépôt : **15.11.88**

(54) **Unité de mémoire vive à plusieurs modes de test et ordinateur muni de telles unités.**

(30) Priorité : **20.11.87 FR 8716115**

(43) Date de publication de la demande :
**24.05.89 Bulletin 89/21**

(45) Mention de la délivrance du brevet :
**19.02.92 Bulletin 92/08**

(84) Etats contractants désignés :
**DE FR GB IT**

(56) Documents cités :
**EP-A- 0 092 245
EP-A- 0 104 442
DE-A- 3 234 117
IEEE JOURNAL OF SOLID-STATE CIRCUITS,
vl. SC-22, no. 5, octobre 1987, pages 663-668,
IEEE, New York, US; T. OHSAWA et al.: " A
60-ns 4-Mbit CMOS DRAM with built-in self-
test function"
IBM TECHNICAL DISCLOSURE BULLETIN,
vol. 17, no. 8, janvier 1975, pages 2396-2397,
New York, US; R.E. BODNER et al.:
"Generation of internal test signals"
IEEE JOURNAL OF SOLID-STATE CIRCUITS,
vol. SC-21, no. 5, octobre 1986, pages 635-642,
IEEE, New York, US; H. McADAMS et al.: "A
1-Mbit CMOS dynamic RAM with design-for
test functions"**

(73) Titulaire : **N.V. Philips' Gloeilampenfabrieken
Groenewoudseweg 1
NL-5621 BA Eindhoven (NL)**

(72) Inventeur : **Ontrop, Hans Société Civile S.P.I.D.
209, rue de l'Université
F-75007 Paris (FR)**
Inventeur : **Pfennings, Leo Société Civile
S.P.I.D.
209, rue de l'Université
F-75007 Paris (FR)**
Inventeur : **Phelan, Cathal Société Civile
S.P.I.D.
209, rue de l'Université
F-75007 Paris (FR)**
Inventeur : **Voss, Peter Société Civile S.P.I.D.
209, rue de l'Université
F-75007 Paris (FR)**
Inventeur : **Davies, Tom Société Civile S.P.I.D.
209, rue de l'Université
F-75007 Paris (FR)**
Inventeur : **O'Connell, Cormac Société Civile
S.P.I.D.
209, rue de l'Université
F-75007 Paris (FR)**
Inventeur : **Prince, Betty Société Civile S.P.I.D.
209, rue de l'Université
F-75007 Paris (FR)**
Inventeur : **Salters, Roelof Société Civile
S.P.I.D.
209, rue de l'Université
F-75007 Paris (FR)**

(74) Mandataire : **Caron, Jean et al
Société Civile S.P.I.D. 156, Boulevard
Haussmann
F-75008 Paris (FR)**

EP 0 317 014 B1

**Description**

L'invention concerne une unité de mémoire vive à accès direct, comportant une entrée d'adresse à plusieurs bits en parallèle et au moins une sortie de données, une entrée de mode-écriture, une entrée de sélection d'unité, et des moyens pour mettre l'unité en mode de test.

Dans de telles mémoires, on cherche toujours à limiter au minimum possible le nombre des connexions entre la mémoire et les circuits extérieurs c'est-à-dire le nombre de broches du boîtier. Il ne serait pas rentable de prévoir des connexions additionnelles permettant un mode de test particulier, connexions qui ne seraient plus utilisées en usage normal, c'est-à-dire pendant la majeure partie du temps.

Il est connu de EP-A-0 092 245 de déclencher le passage en mode de test lorsqu'une séquence de signaux logiques prédéfinie, non contenue dans un jeu de séquences normalement utilisées, mais dont les tensions sont néanmoins comprises dans la gamme de tensions spécifiées pour de tels signaux, est fournie à certaines entrées. Selon ce document, c'est un séquencement ("timing") non convenable d'un second signal par rapport à un premier qui déclenche un mode de fonctionnement déterminé.

La présente invention fournit une unité de mémoire dans laquelle les moyens à mettre en oeuvre pour déclencher le passage dans un mode déterminé sont réduits au maximum. L'unité de mémoire vive selon l'invention est ainsi remarquable en ce que les moyens pour mettre l'unité en mode de test agissent lorsqu'au moins un bit de donnée d'adresse est modifié alors que l'unité a été mise en mode d'écriture.

Pour éviter que certaines situations accidentelles, notamment à la mise en route des alimentations, ne puissent être interprétées comme un ordre de passage en mode de test, avantageusement les moyens pour mettre l'unité en mode de test agissent seulement lorsque ladite séquence de signaux logiques prédéfinie comporte deux violations successives des prescriptions d'un jeu normal de séquences.

L'invention est particulièrement applicable aux mémoires pour lesquelles des changements d'adresse durant un cycle d'écriture ou de lecture est interdit, par exemple celles connues sous les sigles : SRAM, EPROM, EEPROM, DRAM.

Une telle séquence n'oblige pas à forcer un potentiel, et ne risque aucunement d'endommager un circuit. En outre, elle est très facile à décoder.

Avantageusement, l'unité comporte des moyens pour la maintenir en mode de test tant que les entrées de sélection d'unité et de mode écriture ne reçoivent pas simultanément un signal de désactivation.

Il est utile de pouvoir réaliser plusieurs tests différents. Au lieu d'utiliser un mode de déclenchement différent pour chaque type de test à réaliser il est judicieux de prévoir seulement deux modes, à savoir : mode de fonctionnement normal/mode de test, et d'utiliser, une fois le mode de test établi, un jeu d'entrées dans un rôle différent de leur rôle normal afin de sélectionner, parmi plusieurs possibles, quel est le mode de test qui doit être établi.

A cet effet au moins une borne de l'entrée d'adresse de l'unité est reliée à un circuit de décodage de mode de test, dans lequel les données appliquées à ladite borne d'entrée sont utilisées en tant que données définissant la nature du test à réaliser lorsque l'unité est mise en mode de test.

Certains des modes de test impliquent que l'on puisse continuer d'utiliser la mémoire de la façon habituelle, alors qu'elle est en mode de test. Ceci est tout à fait possible avec les dispositions de l'invention, puisqu'aucune des séquences rencontrées en usage normal n'a d'incidence sur le mode de test, excepté celle qui en fait sortir, et qui implique la désactivation de l'unité. Puisque la mémoire peut être utilisée de la façon habituelle, il peut se présenter des données en sortie, qui risquent d'interférer avec des données résultant du test. Afin d'éviter cela, l'unité qui est munie d'un circuit tampon pour la sortie des données contenues dans les cellules de mémoire, est munie en outre d'un deuxième circuit tampon pour la sortie des données résultant d'un test, qui est activé en mode de test, les sorties des circuits tampon étant toutes deux réunies à la sortie de données de l'unité, et la sortie de celui des deux qui n'est pas actif étant à l'état de haute impédance.

Dans les mémoires organisées par bits, il n'y a qu'une seule broche de sortie de données, alors que les résultats issus d'un test peuvent représenter plus de deux possibilités, c'est-à-dire être représentés par un code à plusieurs bits. Pour résoudre ce problème, une unité selon l'invention est munie de moyens pour sérialiser les données résultant d'un test, l'entrée de mode-écriture de l'unité étant connectée à ces moyens pour leur servir d'entrée d'horloge.

En mode de test, l'unité selon l'invention peut notamment :

* présenter à un utilisateur des informations d'identification de l'unité. Ces informations sont nécessaires parceque les procédures de test peuvent dépendre de l'origine de l'unité à tester. La possibilité de lire automatiquement cette information à partir des connexions de l'unité évite d'avoir à les introduire manuellement au clavier du système de test.

* présenter à un utilisateur une information sur l'utilisation ou la non utilisation de circuits de rechange : comme il est quasi-impossible de fabriquer une mémoire sans aucun défaut, on prévoit des circuits de rechange qui sont mis en place à l'issue d'un premier test, pour remplacer les éléments défaillants. Cette mise en place est réalisée de façon permanente et définitive, et est "transparente" c'est-à-dire qu'on ne peut déceler en pratique aucune différence de comportement de l'unité. Néanmoins certains utilisateurs désirent savoir si l'unité qu'ils ont entre les mains fait appel ou non à de tels remplacements.

\* modifier la tension d'une connexion d'alimentation interne, sur laquelle un générateur de tension d'alimentation destinée à un ou plusieurs sous-ensembles de l'unité, produit une tension régulée. Par exemple, pour obtenir un fonctionnement plus sûr de la mémoire, le réseau de cellules de mémoire est alimenté par une alimentation régulée qui est prévue à l'intérieur même de l'unité. Pour procéder à des essais de fiabilité, on cherche souvent à accélérer les processus de dégradation, notamment en augmentant la tension d'alimentation. On peut aussi désirer, afin de caractériser le comportement électrique, relever les variations de certains paramètres en fonction de la tension d'alimentation. Ceci n'est pas possible a priori du fait que l'alimentation interne régulée n'est pas accessible. C'est pourquoi il est utile de prévoir que, dans un des modes de test, on relie, plus ou moins directement, l'alimentation interne du réseau à l'alimentation générale externe.

\* procéder à un auto-contrôle.

Un ordinateur muni d'une pluralité d'unités de mémoire selon l'invention est avantageusement muni de moyens pour adresser sélectivement chaque unité et la mettre en mode de test. Si les unités sont munies d'une possibilité d'auto-contrôle l'ordinateur est avantageusement muni de moyens pour donner des ordres d'auto-contrôle successivement à chacune desdites unités de mémoire, pour déterminer ensuite un délai prédéfini, et pour, à l'issue dudit délai, lire successivement les données présentées à la sortie de chacune des unités de mémoire dans le même ordre et avec le même rythme que ceux utilisés pour donner les ordres d'auto-contrôle. Ceci procure l'avantage que le temps total de contrôle de l'ensemble des mémoires est à peine supérieur au temps de contrôle d'une seule mémoire, c'est-à-dire beaucoup plus courte que si l'ordinateur devait gérer lui-même les étapes de ce contrôle et ceci pour chaque mémoire tour à tour.

L'accès au mode de test peut être utilisé dans plusieurs environnements :

– test fonctionnel chez le fabricant

– test de réception chez le client

– test après incorporation à un équipement, par le client de l'équipement.

Dans la plupart des modes de test possibles, on peut toujours accéder à l'unité comme à une mémoire normale, à l'exception de la séquence qui fait sortir du mode-test.

Une unité selon l'invention est avantageusement réalisée sous forme d'un circuit intégré monolithique.

La description qui va suivre, en regard des dessins annexés décrivant des exemples non limitatifs fera bien comprendre comment l'invention peut être réalisée.

La figure 1 représente schématiquement l'ensemble des moyens selon l'invention.

La figure 2 représente un diagramme de signaux constituant une séquence déclenchant la mise en mode de test.

La figure 3 représente un diagramme de signaux constituant une séquence qui fait sortir du mode de test.

la figure 4 représente un exemple de réalisation des éléments référencés 5 et 7 sur la figure 1.

La figure 5 est un diagramme de temps illustrant la sérialisation d'informations.

La figure 6 représente un exemple de réalisation de l'élément référencé 4 sur la figure 1.

La figure 7 représente un exemple de réalisation des moyens pour donner des indications sur l'utilisation de circuits de rechange.

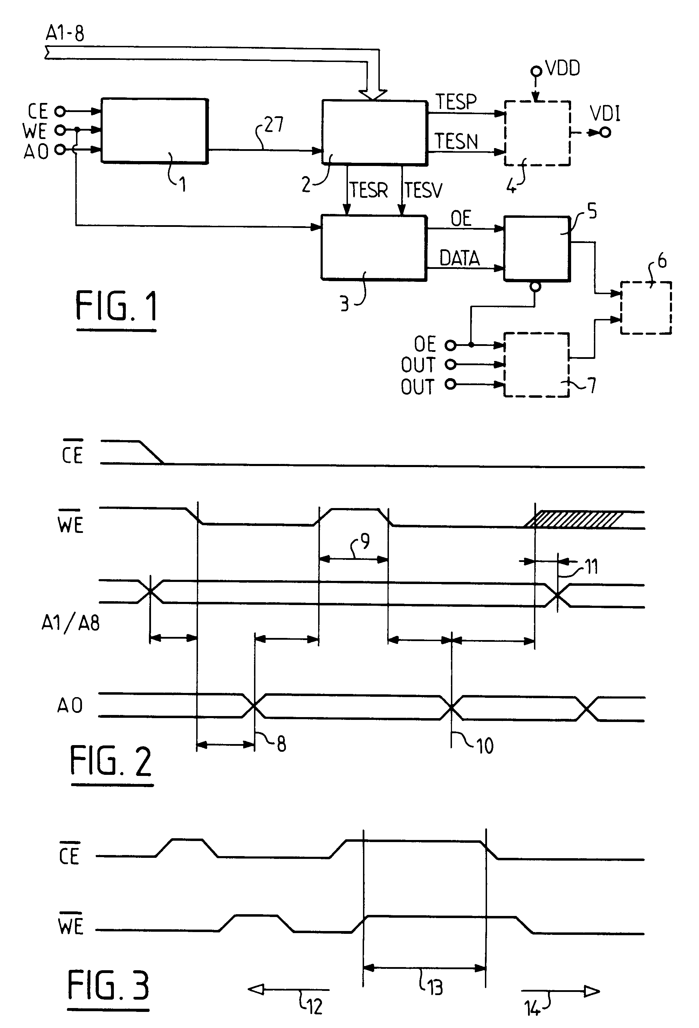

L'unité de mémoire qui sert d'exemple à la description qui va suivre est une unité de mémoire statique, c'est-à-dire que ses cellules de mémoire sont constituées d'une bascule ("flip-flop") pour chaque bit, qui peut rester en permanence dans un état, sans requérir de rafraîchissement périodique. Elle est à accès direct c'est-à-dire qu'on peut accéder immédiatement à n'importe quel bit de la mémoire au moyen de son adresse. Elle est ici organisée par bits et a une capacité de 256 K x 1. Elle possède donc des entrées capables d'adresser 256 K, soit 18 broches, numérotées de "A0" à "A17". Elle possède en outre deux broches d'alimentation ("masse" et "VDD"), une broche d'entrée de données à mémoriser "DIN", une broche de sortie de données "DOUT", une broche d'entrée de sélection d'unité "CE" et une broche d'entrée de mode-écriture "WE", ce qui fait au total 24 broches. Il est bien évident que les moyens qui vont être décrits ci-après pourraient s'appliquer à d'autres unités dont la capacité et/ou l'organisation seraient différentes. La figure 1 représente en trait plein les éléments incorporés dans l'unité et qui sont propres à l'invention, et en traits pointillés, des éléments connus faisant partie de l'unité. L'élément référencé 1 est relié aux entrées CE, WE et à la broche d'adresse A0. Il constitue des moyens de déclenchement du mode de test. Il détecte si une séquence de signaux logiques prédéfinie habituellement interdite, c'est-à-dire non contenue dans un jeu de séquences normalement utilisées, mais dont les tensions sont néanmoins comprises dans la gamme de tensions spécifiées pour de tels signaux, est fournie sur les entrées WE, CE, A0. Si une telle séquence est détectée, il fournit à l'élément 2 un signal de mise en mode de test.

A propos des entrées WE, CE, il est rappelé que, pour des raisons liées à la technologie, on utilise souvent des commandes valides pour la valeur zéro :

ainsi, la notation $\overline{CE}$ représentant l'inverse de CE, la commande $\overline{CE}$ = 0 est équivalente à la commande CE = 1. La broche CE sert à choisir une unité parmi plusieurs unités : lorsque CE = 0 l'unité n'est pas en service, sa sortie de données DOUT est à l'état de haute impédance pour (les sorties de toutes les unités étant reliées ensemble) ne pas gêner la sortie de celle des unités pour laquelle CE = 1, et qui est donc "sélectionnée".

A titre de séquence interdite, la séquence illustrée sur la figure 2 a été choisie. D'abord la connexion $\overline{CE}$ passe ou reste à zéro, l'unité est donc sélectionnée. A ce moment les adresses A1-A8 s'établissent ou sont déjà établies. Ensuite la connexion $\overline{WE}$ passe aussi à zéro. Ceci veut dire qu'on établit le mode d'écriture : le passage de $\overline{WE}$ à zéro est un signal qui déclenche dans la mémoire l'enregistrement de la donnée présente sur l'entrée de donnée (non représentée), dans la cellule de mémoire qui correspond à l'adresse présentée sur les entrées d'adresse A0-A17. Il va de soi qu'au moment où l'on donne l'ordre d'envoyer une donnée à une certaine adresse, il ne faut plus modifier cette adresse. Une telle modification constitue donc une séquence habituellement interdite. En pratique il suffit de changer un seul des 18 bits d'adresse pour constituer une séquence interdite. On a choisi ici l'entrée A0 pour déclencher le mode de test. Lorsque A0 est inversé au temps référencé 8, le mode de test peut être déclenché. Toutefois pour augmenter la sécurité on a choisi de prévoir une redondance, c'est à dire que l'on veut activer le mode de test seulement quand la séquence comporte deux violations successives des prescriptions d'un jeu normal de séquences. On remonte donc $\overline{WE}$ à 1 pendant la durée 9 puis on le ramène à zéro avant de changer à nouveau A0 au temps 10. Alors le mode de test est enclenché.

Il faut noter qu'au lieu de remonter $\overline{WE}$ entre les deux modifications de A0, on aurait pu aussi bien remonter $\overline{CE}$, ce qui créerait aussi une mise en mode d'écriture à la fin du temps 9. Le choix des broches A0, WE, CE est arbitraire, et dans certains cas il serait possible d'en choisir d'autres, pourvu qu'elles permettent l'application d'une séquence inattendue. Par exemple certaines mémoires possèdent une broche supplémentaire d'autorisation pour commander la sortie ("Output Enable") et l'activation de cette broche pendant un cycle d'écriture pourrait être utilisée pour déclencher le passage en mode de test.

La réalisation de l'élément 1 au moyen des circuits logiques de base est élémentaire pour l'homme du métier, par exemple au moyen d'une bascule RS enregistrant le passage vers zéro de WE et de CE, et autorisant dès lors une bascule D pour détecter la transition sur A0, bascule dont la sortie autorise l'entrée en action d'un deuxième groupe identique qui détectera la deuxième séquence WE, A0, et mémorisera un signal d'activation du mode de test, à fournir sur la connexion 27.

L'élément 1 contient aussi des moyens pour détecter la séquence représentée en 13 à la figure 3. Pendant la période indiquée par 12, les entrées WE ou CE peuvent comporter des parties de signal indiquant une désactivation ($\overline{WE}$ = 1 ou $\overline{CE}$ = 1), mais pas ensemble, et l'unité est maintenue en mode de test. Lorsque, comme indiqué en 13, l'entrée de sélection d'unité CE et celle de mode écriture WE reçoivent simultanément un signal de désactivation, après un délai pour confirmer la séquence, l'état de test est abandonné et le signal change sur la connexion 27. Là encore, les moyens pour détecter une telle séquence sont aisément réalisés par l'homme du métier à partir d'éléments logiques de base, par exemple à l'aide d'une porte ET pour détecter WE x CE = 1, associée à un circuit temporisateur.

L'élément 2 est un circuit de décodage de mode de test qui reçoit de la connexion 27 le signal de mise en mode de test, et est en outre relié à un ensemble de bornes d'entrée d'adresse de l'unité, ici l'ensemble A1-A8, et les données appliquées aux dites bornes d'entrée sont utilisées comme données définissant la nature du test à effectuer. L'élément 2 est une sorte de démultiplexeur qui à partir du mot d'adresse A1-A8 engendre un signal sur une connexion parmis connexions, reliées chacune à un circuit spécialisé selon le test à réaliser. Avec les huit bits d'adresse A1-A8, il serait possible de définir 256 modes de test différents. En pratique, on s'est contenté dans le présent exemple d'en utiliser quatre. L'élément 2 comporte un circuit OU à six entrées à l'aide duquel on vérifie que les bits A3-A8 sont tous à zéro, et un démultiplexeur "2 vers 4" qui selon la combinaison des bits A1 et A2 génère un signal sur une et une seule des quatre connexions TESP, TESN, TESR, TESV.

Comme on l'a indiqué en introduction, il est utile de pouvoir agir sur l'alimentation interne du réseau de cellules de mémoire. Ceci est obtenu à l'aide de l'élément 4, auquel aboutissent les connexions TESP et TESN.

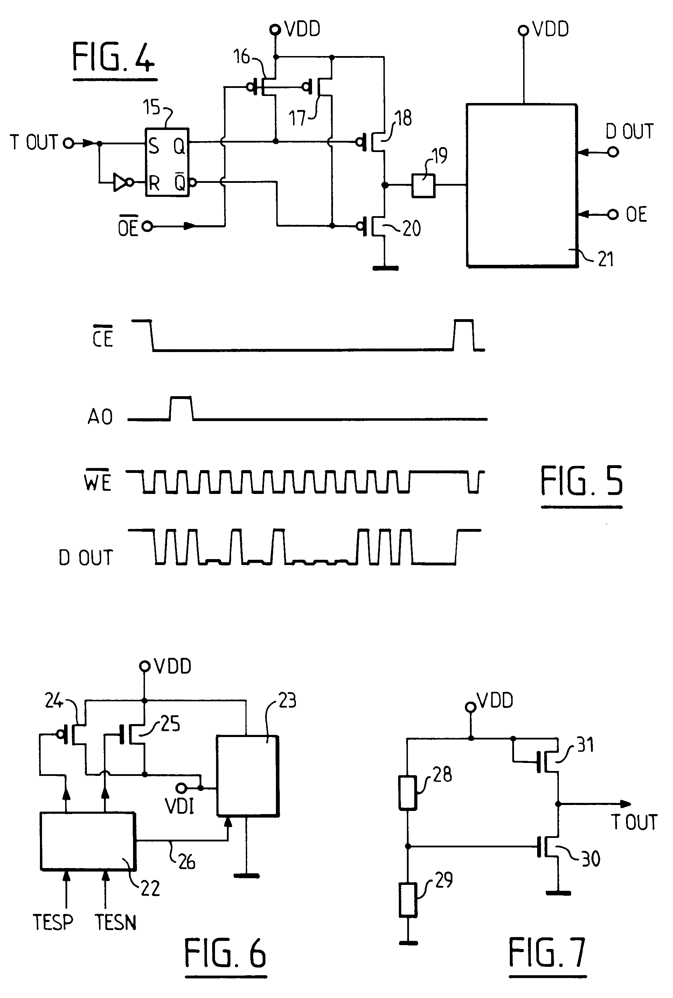

Cet élément est représenté plus en détail à la figure 6. Il comporte un circuit 23 qui engendre à partir de la tension d'alimentation générale VDD une tension VDI régulée. Ce circuit peut être mis hors service, c'est-à-dire qu'il n'impose alors plus la tension VDI ou bien sa tension peut être modifiée, lorsqu'il reçoit un signal adhoc sur une connexion logique 26. Les trajets principaux drain-source de deux transistors 24 et 25 en parallèle l'un avec l'autre relient la connexion d'alimentation VDD à la connexion d'alimentation VDI. Ces deux transistors sont de très grande dimension, par exemple 1000 fois plus larges qu'un transistor de cellule mémoire.

L'ensemble de la mémoire est réalisé en technologie "MOS complémentaire", et le transistor 24 est ici de type P, alors que le transistor 25 est de type N. La tension VDD est bien entendu positive. Lorsque le signal TESP est actif, le circuit logique de commande 22 engendre une tension basse sur les grilles des deux transistors 24 et 25 : le transistor PNP 24 est donc conducteur et le transistor NPN 25 est bloqué. La tension VDI est alors reliée sans seuil à la tension VDD. Lorsque c'est le signal TESN qui est actif, le circuit de commande 22 engendre une tension haute sur les deux grilles 24, 25 : le transistor PNP 24 est bloqué et le transistor NPN 25 est conducteur, mais introduit une différence de tension ("tension de seuil") entre VDD et VDI.

Lorsqu'enfin aucun des signaux TESP ou TESN n'est actif, le circuit 22 engendre une tension haute sur la grille du transistor 24, et une tension basse sur la grille du transistor 25, qui sont alors tous deux bloqués. Ce circuit 22 peut être réalisé aisément à l'aide de quelques portes logiques.

Lorsqu'on désire utiliser l'un des circuits de rechange prévus initialement à titre de redondance, leur mise en action est réalisée par exemple par brûlage d'une résistance placée au pied d'un pont entre VDD et la masse. Du fait de la coupure de la résistance de pied, la tension du point milieu du pont devient égale à VDD et, si elle est par exemple appliquée à la grille d'un transistor NPN, ce dernier devient conducteur. Ceci explique comment on peut fermer un circuit en coupant un conducteur ! Le circuit selon l'invention comporte un circuit spécialisé dont un exemple de réalisation est donné à la figure 7. Il comporte un pont de résistances 28, 29 dont le rapport est tel que la tension du point milieu soit inférieure à la tension de seuil du transistor NPN 30 à la grille duquel ledit point milieu est relié. Le transistor 31 fait office de résistance ; il est de très petite dimension. Lors de l'opération de mise en service de l'un des circuits de rechange prévus, on vient en plus brûler la résistance 29, ce qui rend le transistor 30 conducteur et amène un zéro sur la sortie de test TOUT.

Lorsque l'on désire une information sur la mémoire, par exemple un code identifiant l'usine de fabrication de l'unité et/ou le nom de son vendeur, et/ou la date de fabrication, etc, cette information est un mot de plus de deux bits. Comme il n'y a qu'une broche de sortie de données, l'information doit être fournie en série. A cet effet l'unité est munie de moyens pour sérialiser les données résultant d'un test. Pour ce faire, il est nécessaire de disposer d'une horloge. A cet effet l'entrée de mode écriture WE est reliée à ces moyens pour leur servir d'horloge, et celle-ci est fournie de l'extérieur sur la broche WE. Le résultat est indiqué sur la figure 5. L'entrée WE sert d'horloge et la ligne DOUT porte le signal résultant, ici par exemple 110101000111.

Les circuits spécifiques de test décrits ci-dessus sont contenus dans l'élément 3 de la figure 1, auquel est amené l'horloge WE, les connexions TESR et TESV déclenchent respectivement le test de redondance et la fourniture des données sur le vendeur de la mémoire.

Lorsque des données sont prêtes dans l'élément 3 un signal est fourni sur la connexion OE, et ensuite les données apparaissent sur la connexion DATA. Pour éviter toute interaction entre ces données et celles résultant de l'utilisation normale de la mémoire, qui est possible aussi en période de test, notamment pour caractériser le comportement des cellules de mémoire comme il a été indiqué dans l'introduction, un circuit tampon de sortie est prévu spécialement pour les données résultant d'un test. Ce circuit est représenté à la figure 4. Une bascule R/S 15 maintient la donnée introduite sur TOUT. Sa sortie Q est reliée à la grille d'un transistor PNP 18 dont le trajet de courant est branché entre VDD et la sortie de données de l'unité dont la plage de métallisation est symbolisée par un carré 19. L'autre sortie $\overline{Q}$ de la bascule 15 est branchée à un autre transistor PNP 20, dont le trajet de courant est branché entre la sortie 19 et la masse. Le signal OE autorisant la sortie de données de test est amené aux grilles de deux transistors PNP 16, 17 branchés entre VDD et, respectivement, la sortie Q et la sortie $\overline{Q}$ de la bascule R/S. On suppose que les sorties Q et $\overline{Q}$ ont une impédance interne assez élevée, de façon que les transistors 16 et 17 puissent imposer lorsqu'ils sont conducteurs une tension proche de VDD sur Q et Q. Dès lors, si $\overline{OE}$ = 0, les transistors 16, 17 sont conducteurs, et les deux transistors 18 et 20 sont bloqués, la sortie de l'ensemble étant alors à haute impédance. Avec $\overline{OE}$ ≃ VDD, ce qui correspond au mode de test, les sorties Q et $\overline{Q}$ sont libres et un seul des deux transistors 18 ou 20 est conducteur, selon la valeur de TOUT. La référence 21 désigne un autre bloc qui peut éventuellement être identique à l'ensemble 15-20 décrit ci-dessus, et sert à la sortie des données contenues dans les cellules de mémoire, lors de l'utilisation normale de l'unité. Les données de sortie des cellules de mémoire sont amenées à la borne DOUT, et le bloc est commandé par le signal OE, inverse de $\overline{OE}$ : ainsi un seul des deux blocs [15-20] ou 21 est actif à la fois. En outre, si CE = 0 à l'entrée de l'unité, les deux signaux OE et $\overline{OE}$ sont tous deux à zéro. En pratique le bloc 21 comporte, par rapport à l'ensemble 15-20, des éléments additionnels qui ne font pas partie de l'invention et servent notamment à augmenter la rapidité de sortie des données de mémoire. Par contre, la rapidité de sortie des données de test n'est pas particulièrement recherchée.

On a décrit ci-dessus quatre modes de test différents, dont la sélection se fait à l'entrée au moyen des bits A1-A2. Avec un nombre de bits plus grand, un grand nombre de types de tests peut être sélectionné au moyen des connexions d'adresse. Un test intéressant consiste notamment en un auto-contrôle des cellules de mémoire. Lorsque ce test est déclenché, un compteur, faisant partie des circuits de test, compte de 1 à 256K et son résultat de comptage sert d'adresse pour indiquer une cellule de mémoire à vérifier. Un circuit qui délivre les signaux nécessaires pour le controle d'une cellule est déclenché à chaque fois pour chaque nouvelle adresse de cellule, et si un des contrôles se révèle négatif, une bascule "sémaphore" est enclenchée pour mémoriser le fait qu'un défaut à été rencontré. Pendant la période d'autocontrôle une horloge destinée à piloter le processus est fournie par exemple sur la borne d'entrée WE, comme dans le cas de la sérialisation des données de sortie. Une autre borne pourrait aussi être choisie à cet effet, par exemple une des bornes d'adresse A11-A17 inutilisées pendant ce test. Ces circuits d'autocontrôle ne représentent pas une addition importante au point de vue de la surface nécessaire sur le cristal semiconducteur, l'unité étant, bien entendu, réalisée sous forme d'un circuit intégré monolithique.

Lorsque des unités selon l'invention sont utilisées dans un ordinateur, ce dernier peut être muni de moyens pour adresser sélectivement chaque unité et la mettre en mode de test. Si les unités sont munies d'un système d'auto-contrôle, l'ordinateur est avantageusement muni de moyens pour donner des ordres d'autocontrôle successivement à chacune desdites unités de mémoire et pour déterminer ensuite un délai prédéfini. Le délai en question correspond au temps nécessaire pour l'autocontrôle d'une des mémoires. Comme elles sont toutes identiques, leurs résultats de test vont devenir disponibles dans l'ordre de leur déclenchement de départ et l'ordinateur pourra donc à l'issue dudit délai lire successivement les données présentées à la sortie de chacune des unités de mémoire, dans le même ordre et avec le même rythme que ceux utilisés pour donner les ordres d'autocontrôle.

**Revendications**

1. Unité de mémoire vive à accès direct, comportant une entrée d'adresse à plusieurs bits en parallèle et au moins une sortie de données, une entrée de mode-écriture, une entrée de sélection d'unité, et des moyens pour mettre l'unité en mode de test, caractérisée en ce que les moyens pour mettre l'unité en mode de test agissent lorsqu'au moins un bit de donnée d'adresse est modifié alors que l'unité à été mise en mode d'écriture.

2. Unité de mémoire selon la revendication 1, caractérisée en ce que les moyens pour mettre l'unité en mode de test agissent seulement lorsque la séquence de mise en mode d'écriture suivie de la modification d'un bit d'adresse est répétée deux fois de suite.

3. Unité de mémoire selon la revendication 2, caractérisée en ce que les moyens pour mettre l'unité en mode de test agissent par suite de la modification d'un seul des bits d'adresse.

4. Unité de mémoire selon l'une quelconque des revendications 1 à 3, caractérisée en ce qu'elle comporte des moyens pour la maintenir en mode de test tant que les entrées de sélection d'unité et de mode écriture ne reçoivent pas simultanément un signal de désactivation.

5. Unité de mémoire selon l'une quelconque des revendications 1 à 4, caractérisée en ce qu'au moins une borne de l'entrée d'adresse de l'unité est reliée à un circuit de décodage de mode de test, dans lequel les données appliquées à ladite borne d'entrée sont utilisées en tant que données définissant la nature du test à réaliser lorsque l'unité est mise en mode de test.

6. Unité de mémoire selon l'une quelconque des revendications 1 à 5, munie d'un circuit tampon pour la sortie des données contenues dans les cellules de mémoire, caractérisée en ce qu'elle est munie en outre d'un deuxième circuit tampon pour la sortie des données résultant d'un test, qui est activé en mode de test, les sorties des circuits tampon étant toutes deux réunies à la sortie de données de l'unité, et la sortie de celui des deux qui n'est pas actif étant à l'état de haute impédance.

7. Unité de mémoire selon l'une quelconque des revendications 1 à 6, munie d'une broche de sortie de données unique, caractérisée en ce qu'elle est munie de moyens pour sérialiser les données résultant d'un test, l'entrée de mode-écriture de l'unité étant connectée à ces moyens pour leur servir d'entrée d'horloge.

8. Unité de mémoire selon une quelconque des revendications 1 à 7, caractérisée en ce qu'elle est munie de moyens pour fournir à un utilisateur, en mode de test, une information d'identification de l'unité.

9. Unité de mémoire selon une quelconque des revendications 1 à 8, munie de circuits de rechange destinés à être utilisés en permanence à la place de circuits normaux en cas de défaut d'un ou plusieurs de ces derniers, caractérisée en ce qu'elle est munie de moyens pour fournir à l'utilisateur en mode de test, une information sur l'utilisation ou la non-utilisation d'un circuit de rechange.

10. Unité de mémoire selon une quelconque des revendications 1 à 9, munie d'un générateur de tension interne opérant à partir d'une entrée d'alimentation de l'unité, destiné à alimenter un ou plusieurs sous-ensembles de l'unité et produisant sur une connexion d'alimentation interne une tension régulée, caractérisée en ce qu'elle est munie de moyens pour modifier la tension appliquée à ladite connexion d'alimentation interne, en mode de test.

11. Unité de mémoire selon la revendication 10, caractérisée en ce que lesdits moyens établissent une liaison entre ladite connexion d'alimentation interne et l'entrée d'alimentation de l'unité.

12. Unité de mémoire selon une quelconque des revendication 1 à 11, caractérisée en ce qu'elle est munie de moyens pour procéder à un autocontrôle, en mode de test.

13. Unité de mémoire vive statique à accès direct, caractérisée en ce qu'elle comporte des moyens selon l'une quelconque des revendications 1 à 12.

14. Unité selon l'une quelconque des revendications 1 à 13, caractérisée en ce qu'elle est réalisée sous forme d'un circuit intégré.

15. Ordinateur muni de plusieurs unités de mémoire selon l'une quelconque des revendications 1 à 14, caractérisé en ce qu'il est muni de moyens pour adresser sélectivement chaque unité et la mettre en mode de test.

16. Ordinateur muni de plusieurs unités de mémoire selon la revendication 12, caractérisé en ce qu'il est muni de moyens pour donner des ordres d'autocontrôle successivement à chacune desdites unités de mémoire, pour déterminer ensuite un délai prédéfini, et pour, à l'issue dudit délai, lire successivement les données présentées à la sortie de chacune des unités de mémoire, dans le même ordre et avec le même rythme que ceux utilisés pour donner les ordres d'autocontrôle.


**Patentansprüche**

1. Direktzugriffsspeichereinheit mit einem Parallel-Mehrbit-Adreßeingang und wenigstens einem Datenausgang, einem Schreibbetriebseingang, einem Einheitwähleingang und Mitteln zum Umschalten der Einheit in den Prüfbetrieb, dadurch gekennzeichnet, daß die Mittel zum Umschalten der Einheit in den Prüfbetrieb ansprechen, wenn wenigstens ein Adreßdatenbit geändert und die Einheit in den Schreibbetrieb geschaltet wird.

2. Speichereinheit nach Anspruch 1, dadurch gekennzeichnet, daß die Mittel zum Umschalten der Einheit in den Prüfbetrieb nur dann ansprechen, wenn die Folge zum Einschalten des Schreibbetriebs mit folgender Änderung eines Adreßbits zweimal hintereinander wiederholt wird.

3. Speichereinheit nach Anspruch 2, dadurch gekennzeichnet, daß die Mittel zum Umschalten der Einheit in den Prüfbetrieb infolge der Änderung eines einzigen Adreßbits ansprechen.

4. Speichereinheit nach einem der Ansprüche 1 bis 3, dadurch gekennzeichnet, daß die Einheit Mittel zum derartigen Instandhalten des Prüfbetriebs enthält, daß der Einheitwähleingang und der Schreibbetriebeingang nicht gleichzeitig ein Entaktivierungssignal empfangen.

5. Speichereinheit nach einem der Ansprüche 1 bis 4, dadurch gekennzeichnet, daß wenigstens eine Adreßeingangsklemme mit einer Prüfbetriebdecoderschaltung verbunden ist, in der die der Eingangsklemme zugeführten Daten als Daten verwendet werden, die die Art der zu verwirklichenden Prüfung bestimmen, wenn die Einheit in den Prüfbetrieb geschaltet wird.

6. Speichereinheit nach einem der Ansprüche 1 bis 5, mit einer Pufferschaltung für den Ausgang der in den Speicherelementen enthaltenen Daten, dadurch gekennzeichnet, daß die Einheit außerdem mit einer zweiten Pufferschaltung für den Ausgang der restlichen Daten einer Prüfung versehen ist, wobei diese Schaltung im Prüfbetrieb anspricht, die zwei Ausgänge der Pufferschaltungen beim Ausgang der Einheitsdaten zusammengeführt werden und der nicht aktive Ausgang der beiden sich im Zustand mit hoher Impedanz befindet.

7. Speichereinheit nach einem der Ansprüche 1 bis 6, mit einer einzigen Datenausgangsklemme, dadurch gekennzeichnet, daß die Einheit mit Mitteln zum Aufreihen der aus einer Prüfung gewonnenen Daten versehen ist, wobei der Schreibbetriebseingang mit diesen Mitteln verbunden ist, um für sie als Takteingang zu dienen.

8. Speichereinheit nach einem der Ansprüche 1 bis 7, dadurch gekennzeichnet, daß die Einheit mit Mitteln zum Eingeben einer Einheitidentifikationsinformation im Prüfbetrieb in eine Benutzereinrichtung versehen ist.

9. Speichereinheit nach einem der Ansprüche 1 bis 8, mit Ersatzschaltungen zur dauerhaften Verwendung an der Stelle üblicher Schaltungen bei Fehlbetrieb einer oder mehrerer dieser letztgenannten Schaltungen, dadurch gekennzeichnet, daß die Einheit mit Mitteln zum Eingeben einer Information zur Verwendung oder Nichtverwendung einer Ersatzschaltung im Prüfbetrieb in eine Benutzereinrichtung versehen ist.

10. Speichereinheit nach einem der Ansprüche 1 bis 9, mit einem inneren Spannungsgeber, der zum Betrieb von einem Einheitsversorgungseingang ausgeht und zum Speisen einer oder mehrerer Untereinrichtungen der Einheit dient, der an einer inneren Speiseverbindung eine geregelte Spannung erzeugt, dadurch gekennzeichnet, daß die Einheit mit Mitteln zum Ändern der der inneren Speiseverbindung zugeführten Spannung im Prüfbetrieb versehen ist.

11. Speichereinheit nach Anspruch 10, dadurch gekennzeichnet, daß die Mittel eine Verknüpfung zwischen der inneren Speiseverbindung und dem Einheitsspeiseeingang aufweisen.

12. Speichereinheit nach einem der Ansprüche 1 bis 11, dadurch gekennzeichnet, daß die Einheit mit Mitteln zur Durchführung einer Eigekontrolle im Prüfbetrieb versehen ist.

13. Statischer Direkzugriffsspeichereinheit, dadurch gekennzeichnet daß die Einheit Mittel nach einem der Ansprüche 1 bis 12 enthält.

14. Einheit nach einem der Ansprüche 1 bis 13, dadurch gekennzeichnet, daß die Einheit als integrierte Schaltung verwirklicht ist.

15. Rechner mit mehreren Speichereinheiten nach einem der Ansprüche 1 bis 14, dadurch gekennzeichnet, daß er mit Mitteln zum selektiven Adressieren jeder Einheit und zum Umschalten der Einheit in den Prüfbetrieb versehen ist.

16. Rechner mit mehreren Speichereinheiten nach Anspruch 12, dadurch gekennzeichnet, daß er mit Mitteln zum Ausgeben von Eigenkontrollbefehlen an jede der aufeinanderfolgenden Speichereinheiten zum anschließenden Bestimmen einer vorgegebenen Verzögerung und beim Auftreten dieser Verzögerung zum aufeinanderfolgenden Lesen der am Ausgang jeder der Speichereinheiten vorliegenden Daten in derselben Reihenfolge und mit demselben Takt als die zum Ausgeben der Eigenkontrollbefehle benutzten Daten versehen ist.

## Claims

1. A direct random access memory unit, comprising a parallel multibit address input and at least one data output, a write mode input, a unit selection input, and means for switching the unit to the test mode, characterized in that the means for switching the unit to the test mode are activated when at least one address data bit is modified when the unit has been switched to the write mode.

2. A memory unit as claimed in Claim 1, characterized in that the means for switching the unit to the test mode are activated only when the write mode switching sequence, followed by the modification of an address bit, is repeated twice in succession.

3. A memory unit as claimed in Claim 2, characterized in that the means for switching the unit to the test mode are activated by the modification of a single one of the address bits.

4. A memory unit as claimed in any one of the Claims 1 to 3, characterized in that it comprises means for maintaining the unit in the test mode for as long as the unit selection input and the write mode input do not simultaneously receive a deactivation signal.

5. A memory unit as claimed in any one of the Claims 1 to 4, characterized in that at least one address input terminal of the unit is connected to a test mode decoding circuit in which the data applied to said input terminal is used as data defining the nature of the test to be performed when the unit is switched to the test mode.

6. A memory unit as claimed in any one of the Claims 1 to 5, comprising a buffer circuit for the output of data stored in the memory cells, characterized in that it also comprises a second buffer circuit for the output of data resulting from a test, said second buffer circuit being activated in the test mode, the output of the buffer circuits both being connected to the data output of the unit, the output of that one of the two which is not active being in the high impedance state.

7. A memory unit as claimed in any one of the Claims 1 to 6, comprising a single data output pin, characterized in that it comprises for serializing the data resulting from a test, the write mode input of the unit being connected to said means in order to serve them as a clock input.

8. A memory unit as claimed in any one of the Claims 1 to 7, characterized in that it comprises means for supplying a user with unit identification information in the test mode.

9. A memory unit as claimed in any one of the Claims 1 to 8, comprising substitute circuits intended for permanent use instead of the normal circuits in the event of failure of one or more of the latter, characterized in that it comprises means for supplying the user, in the test mode, with information concerning the use or non-use of a substitute circuit.

10. A memory unit as claimed in any one of the Claims 1 to 9, comprising an internal voltage generator operating from a power supply input of the unit and intended to power one or more sub-assemblies of the unit and to produce a regulated voltage on an internal supply connection, characterized in that it comprises means for modifying, in the test mode, the voltage applied to said internal supply connection.

11. A memory unit as claimed in Claim 10, characterized in that said means establish a connection between said internal supply connection and the power supply input of the unit.

12. A memory unit as claimed in any one of the Claims 1 to 11, characterized in that it comprises means for performing a self-check in the test mode.

13. A direct access static random access memory unit, characterized in that it comprises means as claimed in any one of the Claims 1 to 12.

14. A unit as claimed in any one of the Claims 1 to 13, characterized in that it is realized in the form of an integrated circuit.

15. A computer comprising a plurality of memory units as claimed in any one of the Claims 1 to 14, characterized in that it comprises means for selectively addressing each unit and for switching it to the test mode.

16. A computer comprising a plurality of memory units as claimed in Claim 12, characterized in that it comprises means for issuing self-check commands successively to each of said memory units in order to determine subsequenly a predefined delay and, upon expiry of said delay, to read successively the data present at the output of each of said memory units in the same order and at the same rate as used for issuing the self-check commands.

A1-8

CE ○→
WE ○→
A0 ○→

1

27

2

TESP
TESN

VDD
VDI

4

TESR    TESV

OE

DATA

5

6

OE ○→
OUT ○→
OUT ○→

7

<u>FIG. 1</u>

CE

WE

9

11

A1/A8

8

10

A0

<u>FIG. 2</u>

CE

WE

13

12

14

<u>FIG. 3</u>

FIG.4

VDD

T OUT

S   Q
15
R   Q̄

OE

16

17

18

19

20

D OUT

OE

21

VDD

CE

AO

WE

D OUT

FIG.5

VDD

24

25

23

VDI

22

TESP   TESN

26

FIG.6

VDD

28

31

T OUT

30

29

FIG.7